(19) Europäisches Patentamt
European Patent Office
Office européen des brevets

(11) **EP 4 044 261 A1**

(12) **EUROPEAN PATENT APPLICATION**

(43) Date of publication:
**17.08.2022 Bulletin 2022/33**

(21) Application number: **21156970.2**

(22) Date of filing: **12.02.2021**

(51) International Patent Classification (IPC):
**H01L 31/12** (2006.01)     **G02F 1/015** (2006.01)

(52) Cooperative Patent Classification (CPC):
**H01L 31/12; H01L 31/032; H01L 31/036;
H01L 31/105**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ETH Zurich
8092 Zurich (CH)**

(72) Inventors:
• **THUREJA, Deepankur
  5417 Untersiggenthal (CH)**
• **ANANTHA MURTHY, Puneet
  8048 Zürich (CH)**
• **KRONER, Martin
  8049 Zürich (CH)**
• **POPERT, Alexander
  8050 Zürich (CH)**
• **IMAMOGLU, Atac
  8032 Zürich (CH)**

(54)  **CONFINEMENT OF NEUTRAL EXCITONS IN A SEMICONDUCTOR LAYER STRUCTURE**

(57)  A method for laterally confining neutral excitons in a semiconductor layer structure (11) of a solid-state device comprises creating an inhomogeneous electric field (F) in the semiconductor layer structure (11), the electric field (F) having an in-plane field component ($F_x$) whose magnitude varies along at least at least one confinement direction (x) in the device plane, the magnitude of the in-plane field component ($F_x$) having a maximum along the confinement direction (x). In this manner a lateral confining potential ($V(x)$) for neutral excitons is caused around the maximum. The solid-state device (10) is irradiated with light to create neutral excitons in the semiconductor layer structure (11). The neutral excitons are laterally confined along the confinement direction (x) by the lateral confining potential ($V(x)$).

FIG. 1

EP 4 044 261 A1

**Description**

**TECHNICAL FIELD**

The present invention relates to a method for laterally confining neutral excitons in a semiconductor layer structure of a solid-state device, and to a device that is configured for carrying out the method.

**PRIOR ART**

An exciton is a bound state of an electron and an electron hole. An exciton can form when a material absorbs a photon, the photon exciting an electron from the valence band into the conduction band. In turn, this leaves behind a positively charged electron hole in the valence band. The electron and the hole are attracted by the electrostatic Coulomb force, forming a quasi-particle or, expressed differently, an elementary excitation of the semiconductor. An exciton is electrically neutral, i.e., it has no net charge.

Excitons play an important role in optoelectronics and quantum photonics. In such contexts, it may be desired to confine excitons along one dimension (i.e., along a straight or curved line) or in zero dimensions (i.e., at a predefined point). For some applications, so-called quantum confinement may be desired, i.e., confinement that is sufficiently strong to cause an exciton to have two or more discrete bound motional eigenstates in the confining potential.

Some authors use the term "exciton" more broadly to include "charged excitons", which comprise one additional electron or hole. Charged excitons are sometimes also called "trions". It has been suggested in the prior art to confine and manipulate trions by electrostatic potentials. For instance, K. Wang et al., "Electrical control of charged carriers and excitons in atomically thin materials", Nature Nanotechnology 13, 128 (2018) discloses controlled localization of trions in a gate-defined monolayer $MoSe_2$ quantum dot. No confinement of neutral excitons was achieved.

In the present disclosure, unless indicated otherwise, the term "exciton" is to be understood to relate to neutral excitons. Neutral excitons are intrinsically more challenging to electrically confine than charged particles.

In the prior art, confinement of neutral excitons has been demonstrated for spatially indirect excitons, where the electron and the hole are created in in spatially separated quantum wells with an insulating barrier layer in between, giving rise to a permanent electric dipole moment of the exciton. The permanent dipole moment can be employed to manipulate the excitons. Rapaport et al., "Electrostatic traps for dipolar excitons", Phys. Rev. B 72, 075428 (2005) disclose a two-dimensional electrostatic trap for indirect excitons, using a nonuniform electric field for confinement. The trap comprises a double quantum well (DQW) structure arranged above a bottom electrode. A semitransparent top gate electrode covers a portion of the DQW structure. An electric field is applied between the top and bottom electrodes. Indirect excitons are trapped under the top gate electrode due to the interaction of their permanent electric dipole moment with the out-of-plane component of the electric field. The in-plane component of the electric field near the boundary of the top gate electrode causes exciton ionization and thus reduces the effective trapping lifetime.

A. Gartner et al., "Micropatterned electrostatic traps for indirect excitons in coupled GaAs quantum wells", Physical Review B 76, 085304 (2007) disclose another electrostatic trap for indirect excitons. The trap comprises a DQW structure comprising coupled GaAs quantum wells. Indirect excitons are confined at the perimeter of a $SiO_2$ area sandwiched between the surface of the GaAs heterostructure and a semitransparent top gate electrode. The confining potential is due to a combination of an effective field enhancement for the out-of-plane component of the electric field and the quantum confined linear Stark effect. The in-plane component must be kept small to avoid ionization of the excitons.

G. J. Schinner et al., "Confinement and interaction of single indirect excitons in a voltage-controlled trap formed inside double InGaAs quantum wells", Physical Review Letters 110, 1 (2013) disclose another example of an electrostatic trap for indirect excitons, combining a DQW structure with gate-defined electrostatic potentials. Confinement is again based on the interaction of the permanent dipole moment of indirect excitons with the out-of-plane component of the electric field, while the in-plane electric field may cause undesired ionization.

WO2007125418A2 discloses an optoelectronic device including a coupled or wide quantum well structure. A localized gate electrode is arranged over a region of the coupled or wide quantum well structure and a semiconductor barrier layer. An optical input and optical output are arranged over other regions of the coupled or wide quantum well structure that are separated by the gate region. The coupled or wide single quantum well structure is dimensioned and formed from materials that create a nonzero distance d between the separated electron and hole of an exciton formed in response to the input, i.e., spatially indirect excitons are formed in the device. The document discloses that the flow of excitons or separated electrons and holes between the optical input and optical output can be controlled by a voltage potentials applied to the localized gate electrode, optical input, and output gates.

Other disclosures that are broadly related to the problem of confining excitons or other quasi-particles include WO2018015738A1, KR102045064B1, and EP3361516A1.

## SUMMARY OF THE INVENTION

In a first aspect, it is an object of the present invention to provide a method of confining neutral excitons in one or zero dimensions, the method being suitable also for spatially direct excitons.

This object is achieved by a method according to claim 1. Further embodiments of the invention are laid down in the dependent claims.

According to the first aspect, the invention provides a method for laterally confining neutral excitons in a semiconductor layer structure of a solid-state device, the semiconductor layer structure comprising at least one semiconductor layer and defining a device plane, the method comprising:

creating an inhomogeneous electric field in the semiconductor layer structure, the electric field having an in-plane field component whose magnitude varies along at least at least one confinement direction in the device plane, the magnitude of the in-plane field component having a maximum along said confinement direction, whereby a lateral confining potential for neutral excitons is caused around the maximum; and

irradiating the solid-state device with light to create neutral excitons in the semiconductor layer structure, the neutral excitons being laterally confined along the confinement direction by the lateral confining potential.

In the method, excitons are confined in a semiconductor layer structure under the action of a strongly inhomogeneous in-plane electric field, which causes a confining potential via the dc Stark effect. The method may be used for confining spatially direct excitons, which may be created in a single semiconductor layer, as well as for confining spatially indirect excitons created in two adjacent semiconductor layers separated by an insulating separating layer.

Creating the inhomogeneous electric field in the semiconductor layer structure may comprise modifying the charge carrier density in the semiconductor layer structure to create a p-doped region and/or an n-doped region. Strong in-plane electric fields may arise at the perimeter of such a doped region. In addition, the confining potential is augmented by repulsive polaronic dressing of excitons by electrons or holes in the surrounding p- or n-doped regions. As both the in-plane field strength and the polaronic dressing effect correlate with the charge carrier density in the p- and n-doped regions, the charge carrier density in these regions should preferably be sufficiently high. Preferably, the p-doped region and/ or the n-doped region have a charge carrier density in the range of $0.1 \cdot 10^{12}$ cm$^{-2}$ to $5 \cdot 10^{12}$ cm$^{-2}$.

Preferably both a p-doped region and an n-doped region are created, the p-doped region and the n-doped region being laterally separated in the device plane by an i-type region. Such an arrangement may cause particularly strong and highly inhomogeneous in-plane fields. The maximum of the magnitude of the in-plane component will then be located in the i-type region between the p-doped region and the n-doped region, and the neutral excitons will be laterally confined in the i-type region.

In the context of the present disclosure, the term "i-type region" or briefly "i-region" is to be understood as referring to a region of a semiconductor layer where the concentrations of conduction electrons and holes are essentially equal, i.e., an i-type region is essentially neutral, the concentration of excess positive or negative charge carriers being negligible. The term "p-doped region" or "p-type region" is to be understood as referring to a region of a semiconductor layer that has an excess of positive charge carriers (holes). According to an alternative but equivalent definition, a "p-doped region" is a region of a semiconductor layer in which the Fermi level is below the Fermi level of the intrinsic semiconductor layer. Similarly, the term "n-doped region" or "n-type region" is to be understood as referring to a region of a semiconductor layer that has an excess of negative charge carriers (conduction electrons) or, equivalently, a region in which the Fermi level is above the Fermi level of the intrinsic semiconductor layer.

The charge carrier density in the semiconductor layer structure may be modified by various means. One possible means is chemical doping, i.e., the creation of excess charge carriers by the introduction of chemical impurities into the semiconductor layer. However, a preferred means is the application of an electric voltage between the semiconductor layer and a gate electrode arranged above or below the semiconductor layer. Creating the p-and/or n-doped region by the application of gate voltages is advantageous in that the exciton confinement can be electrically controlled. The different means for doping may also be combined. For instance, a p-doped region may be created by chemical doping, while an n-doped region may be created by applying a gate voltage between the semiconductor layer and a suitable gate electrode, or vice versa. As another example, it is conceivable that the entire semiconductor layer is first chemically doped, and that the charge carrier density in the thus-doped layer is then modified using one or more gate electrodes to create the p-doped, n-doped and i-type regions.

While creating p- and/or n-doped regions in the semiconductor layer structure is advantageous for achieving a highly inhomogeneous in-plane field, it is to be stressed that an inhomogeneous electric field can be created in the semiconductor layer structure even without doping. Regardless of whether or not doped regions are created in the semiconductor layer, it is advantageous if creating the inhomogeneous electric field in the semiconductor layer structure comprises applying one or more gate voltages between the semiconductor layer and a gate electrode to electrically control the exciton confinement.

Specifically, the solid-state device may comprise an insulating first spacer layer disposed on a first surface of the semiconductor layer structure and a first gate electrode arranged on the first spacer layer. Creating the inhomogeneous electric field in the semiconductor layer structure may then comprise applying a first gate voltage between the first gate electrode and the semiconductor layer structure. The solid-state device may further comprise a second gate electrode arranged on the first spacer layer or on a second spacer layer disposed on a second surface of the semiconductor layer structure opposite to the first spacer layer. Creating the inhomogeneous electric field in the semiconductor layer structure may then further comprise applying a second gate voltage between the second gate electrode and the semiconductor layer structure, the first and second gate voltages having opposite signs.

The spacer layers are preferably made of hexagonal boron nitride (hBN), which is advantageous in that it has a layered structure allowing thin flakes to be readily exfoliated from a bulk crystal. However, other materials may be used, including $SiO_2$, $Al_2O_3$, MgO, $LaAlO_3$, and $SrTiO_3$. Preferably the spacer layers have a thickness in the range of 1 to 200 nm.

The gate voltages required for creating a sufficiently inhomogeneous electric field and/or for achieving sufficient doping depend on various factors, including the properties of the semiconductor material and the thickness of the spacer layers. A typical range for the gate voltages is between -20 and +20 V. A typical range for the resulting out-of-plane electric fields in the spacer layers between each gate electrode and the semiconductor layer 1 V/$\mu$m to 500 V/$\mu$m.

If the first and second gate electrodes are disposed on different spacer layers on opposite sides of the semiconductor layer structure, it is advantageous that the second gate electrode partially overlaps with the first gate electrode when viewed along an out-of-plane direction that is perpendicular to the device plane. In this way, a strongly inhomogeneous in-plane field can be created and exciton confinement can be achieved without aligning the first and second gate electrodes laterally by lithographic patterning on nanoscopic scales. In particular, the gate voltages can be set such that an n- or p-doped region is created in the region of the first gate electrode where no overlap with the second gate electrode exists, and an oppositely doped region is created in the region of overlap, such that the i-type region forms at the edge of the region of overlap along the perimeter of the second gate electrode.

However, it is also conceivable to position the first and second gate electrodes on the same spacer layer and to lithographically pattern these electrodes in such a manner that they have a sufficiently small lateral distance to create a strongly inhomogeneous in-plane field and achieve exciton confinement.

In order to obtain sufficiently strong confinement, the maximum of the magnitude of the in-plane electric field should be sufficiently high, and the spatial extent of the inhomogeneous in-plane field should be sufficiently small. In particular, it is preferred that the maximum of the magnitude of the in-plane field component is at least 10 V/$\mu$m, and that the magnitude of the in-plane field component as a function of position along a straight line along the confinement direction describes a curve having a full width at half maximum (FWHM) of not more than 100 nm.

In some embodiments, the semiconductor layer structure may comprise exactly one semiconductor layer, and spatially direct excitons may be excited in this single layer. In other embodiments, the semiconductor layer structure may comprise two or more semiconductor layers, and spatially direct and/or indirect excitons may be excited in these layers. Both types of excitons may be confined by the proposed method.

Preferably, each of these semiconductor layers has thickness that is sufficiently thin to cause the semiconductor layer to act essentially as a 2D material. In particular, the thickness should be sufficiently small that the electric polarizability of direct excitons in the semiconductor layer perpendicular to the device plane is not more than 10%, preferably not more than 1%, of their electric polarizability in the device plane. In absolute numbers, the thickness of the semiconductor layer is preferably not more than 5 nm, more preferably not more than 2 nm, and it may be less than 1 nm.

The choice of the semiconductor material may be guided by the ease of forming thin layers, by the band structure in the layer, and by the exciton binding energy in the material. Preferably, a semiconductor material is used that can form ultrathin layers with direct bandgap, excitons in the semiconductor layer structure having a binding energy of at least 10 meV, more preferably at least 50 meV.

In advantageous embodiments, the semiconductor layer consists of a transition metal dichalcogenide. A transition metal dichalcogenide is a compound of formula $MX_2$, where M is a transition metal, in particular, Mo or W, and X is a chalcogen, in particular S, Se, or Te. Preferred materials are $MoSe_2$, $WSe_2$, $MoS_2$, $WS_2$, and $MoTe_2$, wherein $MoSe_2$, $WSe_2$, $MoS_2$ are particularly preferred due to their ease of fabrication and handling. These materials advantageous in that they can be formed into monolayers and have an extraordinarily strong exciton binding energy in the range of 50 to 500 meV. However, other semiconductor materials that can form ultrathin layers with a direct bandgap may also be used, including inorganic and organic hybrid perovskites, black phosphorous, bilayer graphene, silicene, antimonene, and certain semiconducting polymers. Examples can be found in T. Low et al., "Polaritons in layered two-dimensional materials", Nature Materials 16, 182-194 (2017), see section "Strong excitons in 2D semiconductors". Further examples of thin semiconducting materials along with the respective synthesis methods can be found in: Tan, C. et al. "Recent Advances in Ultrathin Two-Dimensional Nanomaterials", Chemical Reviews 117, 6225-6331 (2017).

In particularly preferred embodiments, the semiconductor layer is a transition metal dichalcogenide monolayer, in particular, a $MoSe_2$, $MoS_2$ or $WSe_2$ monolayer. For instance, a $MoSe_2$ monolayer has a thickness of approximately 0.65 nm and an exciton binding energy of approximately 200 meV. The ratio of the out-of-plane and in-plane electric polarizabilities in this material is approximately only 0.1%.

The operating conditions of the solid state device are preferably chosen such that the ratio of the exciton binding energy in the semiconductor layer and the exciton linewidth in the confining potential is at least 10. The exciton linewidth is influenced, inter alia, by the operating temperature. Said ratio can therefore be favorably influenced by operating the device at sufficiently low temperature.

In advantageous embodiments, the method is used for quantum confinement, i.e., the confining potential causes the excitons to have at least two discrete bound motional eigenstates in the lateral confining potential. In order to enable the eigenstates to be spectroscopically resolved, the eigenstates should preferably be separated by more than the exciton linewidth in the confining potential. Preferably the eigenstates are separated by an energy splitting of at least 0.5 meV.

In a second aspect, the present invention provides a device that is specifically configured for carrying out the present invention. The device comprises:

a semiconductor layer defining a device plane;
an insulating first spacer layer disposed on a first surface of the semiconductor layer;
a first gate electrode arranged on the first spacer layer;
a second gate electrode arranged on the first spacer layer or on a second spacer layer, the second spacer layer being disposed on a second surface of the semiconductor layer structure opposite to the first spacer layer;
a first voltage source configured to apply a first gate voltage between the first gate electrode and the semiconductor layer; and
a second voltage source configured to apply a second gate voltage between the second gate electrode and the semiconductor layer,
the first and second gate voltages having polarities and magnitudes to cause an inhomogeneous electric field in the semiconductor layer structure, the electric field having an in-plane field component whose magnitude varies along at least one confinement direction in the device plane, the magnitude of the in-plane field component having a maximum along said confinement direction, whereby a lateral confining potential for neutral excitons is caused around the maximum.

The same considerations as for the method of the present invention also apply to the device of the present invention.

In particular, as already outlined above, it is preferred that the second gate electrode is arranged on the second spacer layer and partially overlaps with the first gate electrode when viewed along an out-of-plane direction that is perpendicular to the device plane.

The device may further comprise an optical system configured to irradiate the semiconductor layer with incident light to excite neutral excitons in the semiconductor layer structure.

BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

Fig. 1      shows a schematic side view of a solid-state device according to an embodiment of the present disclosure, not to scale;

Fig. 2      shows a diagram illustrating the band structure of the semiconductor layer as a function of the position along the x direction;

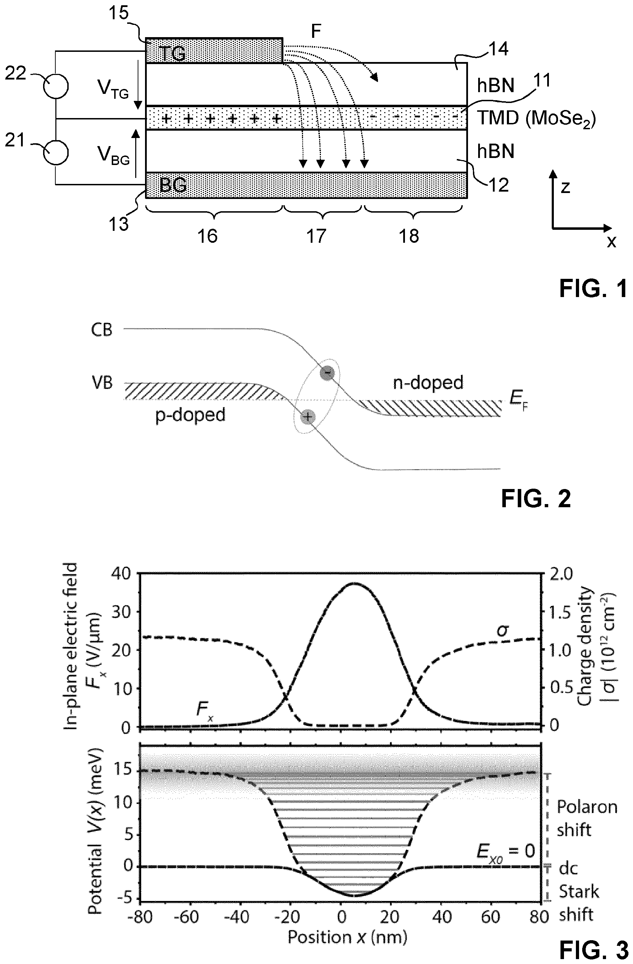

Fig. 3      shows, in the upper panel, a diagram illustrating the spatial distributions of the in-plane field strength $F_x$ and the total charge density $\sigma$ obtained from electrostatic simulations as a function of position x, where x = 0 corresponds to the position of the edge of the top gate electrode in Fig. 1, and, in the lower panel, the total confining potential for excitons stemming from the dc Stark effect due to the in-plane electric field (lower curve) and the repulsive polaronic dressing of the excitons by itinerant holes and electrons in the neighboring doped regions (upper curve shows total potential);

Fig. 4      shows an optical micrograph of a sample studied in the present disclosure; the dashed white line corresponds to the outline of the monolayer $MoSe_2$ flake;

Fig. 5A      illustrates the shape of the top gate (TG) electrode used in the present disclosure, the TG electrode defining a split gate, together with several beam spot positions used in the present disclosure;

Fig. 5B      shows an AFM scan of the split gate (scale bar: 200 nm);

| Fig. 6 | shows a 2D density plot illustrating typical broadband reflectance spectra of the encapsulated TMD monolayer as a function of $V_{BG}$, taken at a position away from the TG (marked by * in Fig. 6), illustrating the exciton resonance in the charge neutral regime ($X_0$) and the attractive ($AP^{\pm}$) and repulsive polaron ($RP^{\pm}$) branches that emerge in the electron and hole doped regimes; |
|---|---|
| Fig. 7 | shows a spectral linecut of Fig. 6 taken at $V_{BG}$ = -3.0 V; |
| Fig. 8 | shows a diagram illustrating measurements of source-drain current as a function of $V_{TG}$ for different $V_{BG}$; |
| Fig. 9 | shows a 2D density plot illustrating the normalized differential reflectance $\Delta R/R$ as a function of photon energy and of $V_{TG}$, taken at the TG edge at $V_{BG}$ = 4 V; |
| Fig. 10 | shows spectral linecuts of Fig. 9 taken at $V_{TG}$ = -3.5 V (dotted line), -5.5 V (dash-dotted line), and -6.2 V (solid line); |
| Fig. 11 | shows a diagram illustrating the estimated shape of total potential V(x) for excitons at $V_{TG}$ = -3.5 V (dotted line), -5.5 V (dash-dotted line), and -6.2 V (solid line); |
| Fig. 12 | shows a 2D density plot illustrating photoluminescence spectra at $V_{BG}$ = 4 V as a function of $V_{TG}$; |
| Fig. 13 | shows a spectral linecut of Fig. 12 taken at $V_{TG}$ = -7 V; |
| Fig. 14 | shows results of Lorentzian fits of resonances for the reflectance (circles) and PL (diamonds) spectra; |
| Fig. 15 | shows a 2D plot of PL measurements at $V_{BG}$ = 5 V and $V_{TG}$ = -6 V as the position of the optical spot on the sample is scanned across the top gate; |
| Fig. 16 | shows a diagram illustrating the oscillator strength of the lowest energy resonance in the PL spatial scan of Fig. 15; |
| Fig. 17 | shows a 2D plot of PL measurements as a function of linear polarization angle taken at $V_{BG}$ = 5 V and $V_{TG}$ = -5.5 V at a position where the spot encompasses two parallel edges; |
| Fig. 18 | shows a polar plot of normalized emission intensity associated with confined states for data shown in Fig. 17; |
| Fig. 19 | shows a 2D density plot illustrating PL measurements as a function of linear polarization angle taken at at $V_{BG}$ = 5 V and $V_{TG}$ = -5.5 V at a position where the optical spot is aligned on the split gate; |
| Fig. 20 | shows a polar plot of normalized emission intensity associated with confined states for data shown in Fig. 19; |
| Fig. 21 | shows a 2D density plot illustrating the normalized reflectance $\Delta R/R$ as a function of photon energy and of $V_{TG}$ for fixed $V_{BG}$ = -8 V, corresponding to hole-doping in region I; |
| Figs. 22-27 | show, in the respective upper panel, a diagram illustrating the spatial distributions of the in-plane field strength $F_x$ (dotted line) and the total charge density $\sigma$ (dash-dotted line) obtained from electrostatic simulations, and, in the respective lower panel, the total confining potential for excitons stemming from the dc Stark effect (broken line) due to the in-plane electric field and the repulsive polaronic dressing of the excitons by itinerant holes and electrons in the neighboring doped regions (total potential shown by solid line), for a plurality of TG voltages, the bottom gate extending over the entire plotted range of the position from -80 nm to 80 nm, and the top gate ranging from -80 nm to 0 nm; |
| Fig. 28 | shows, in a highly schematic manner, an arrangement of gate electrodes for forming a quantum dot; |
| Fig. 29 | shows, in a highly schematic manner, an arrangement of gate electrodes for confining dipolar in-plane excitons in a 1D channel; and |
| Fig. 30 | shows, in a highly schematic manner, an arrangement of gate electrodes for confining dipolar in-plane excitons in an annular region; and |
| Fig. 31 | shows, in a highly schematic manner, an illustration of the experimental setup. |

DESCRIPTION OF PREFERRED EMBODIMENTS

Device concept

A solid-state device according to an embodiment of the present invention is illustrated in Fig. 1.

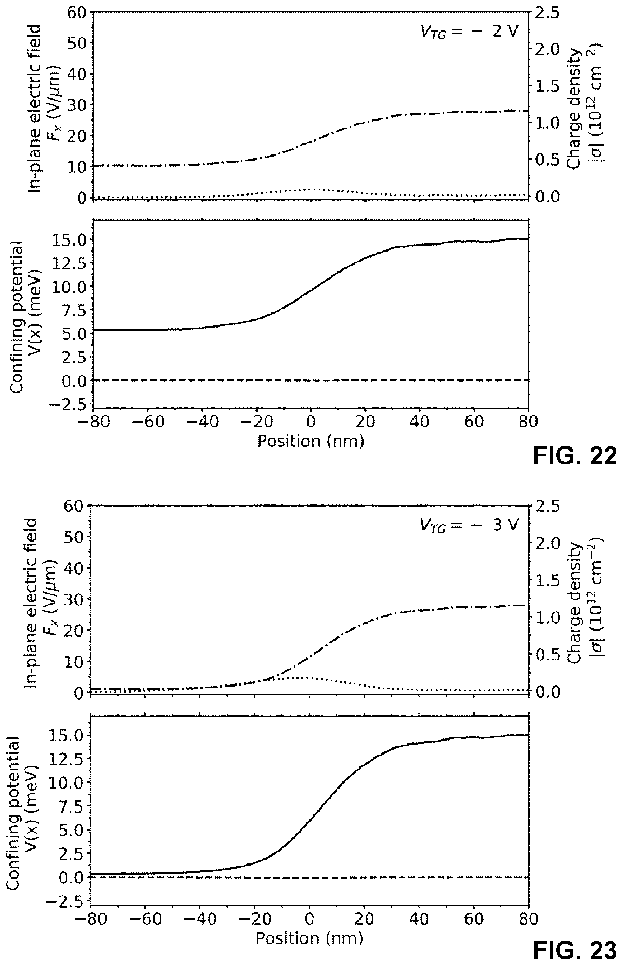

The device comprises a semiconductor layer structure 11, e.g., in the form of a TMD monolayer. An insulating bottom spacer layer 12, e.g., made of hexagonal boron nitride (hBN), covers the bottom surface of the semiconductor layer 11. An electrically conducting, e.g., metallic, bottom gate (BG) electrode 13 is arranged on the bottom spacer layer 12 below the semiconductor layer 11. In the present embodiment, the bottom gate electrode 13 covers the entire bottom surface of the semiconductor layer 11 and is not structured in any particular manner. However, in other embodiments, the bottom gate electrode may be structured, covering only part of the bottom surface of the semiconductor layer 11, as will be discussed in more detail below in connection with Figs. 23-25. An insulating top spacer layer 14, e.g., made of hexagonal boron nitride (hBN), is disposed on the top surface of the semiconductor layer 11 opposite to the bottom spacer layer 12, and an electrically conducting, e.g., metallic, top gate (TG) electrode 15 is arranged on the top insulating layer 14. In the present example, the top gate electrode 15 is structured to only cover part of the top surface of the semiconductor layer 11 and to partially overlap with the bottom gate electrode 13.

Directions are defined as follows: The semiconductor layer defines a device plane. Directions in the device plane (in-plane directions) are designated as x and y. The out-of-plane direction perpendicular to the device plane is designated as z.

A first voltage source 21 provides a bottom gate voltage $V_{BG}$ between the bottom gate electrode 13 and the semiconductor layer 11. A second voltage source 22 provides a top gate voltage $V_{TG}$ between the top gate electrode 15 and the semiconductor layer 11. In the following, the following sign convention is used: The voltage $V_{BG}$ ($V_{TG}$) is considered to be positive if the electric potential of the BG (TG) electrode is higher than the electric potential of the semiconductor layer 11.

By an appropriate choice of the polarities and magnitudes of the bottom and top gate voltages $V_{BG}$ and $V_{TG}$, a p-i-n heterostructure is generated in the semiconductor layer 11. In particular, by setting an appropriate positive bottom gate voltage $V_{BG}$, the semiconductor layer may become n-doped. By setting an appropriate negative top gate voltage $V_{TG}$, the effect of the bottom gate voltage may be counteracted in the portion of the semiconductor layer 11 that is located below the top gate electrode, and a p-doped region 18 can be created in the semiconductor layer 11 below the top gate electrode 15. Most of the remainder of the semiconductor layer 11 will remain n-doped. Along the edge of the top gate electrode 15, a narrow neutral region (i-region) 17 separates the p-doped region 16 from the n-doped region 18. A strong in-plane electric field is present in the neutral region.

Fig. 2 illustrates the resulting band structure in the p-i-n heterostructure, showing the position of the Fermi level relative to the conduction (CB) and valence (VB) bands. In the p-doped region, the Fermi level is in the valence band, while in the n-doped region, the Fermi level is in the conduction band. In the neutral region, the Fermi level is in the band gap between these bands.

Electrostatic simulations of such a p-i-n device provided a quantitative picture of the spatial and voltage dependence of the charge density ($\sigma(x)$) and in-plane electric field ($F_x$) distribution in the vicinity of the TG electrode. Results of electrostatic simulations are illustrated in Fig. 3.

Exciton confinement in the i-region of this device primarily arises from the strong in-plane electric field ($F_x$)

which polarizes the excitons along x and lowers their energy due to a quadratic dc Stark shift $\Delta E_S = \frac{1}{2}\alpha |F_x|^2$, where $\alpha$ is the exciton polarizability. Since $F_x$ vanishes on either side of the i-region (see upper panel of Fig. 3, solid line), falling off rapidly to both sides of the maximum with a FWHM of approximately 40 nm, excitons experience an attractive confining potential towards the local maximum in $F_x(x)$. An additional, new mechanism of confinement stems from polaronic dressing of neutral excitons by itinerant holes and electrons present on either side of the i-region. Excitons generated in the i-region become repulsive polarons as they enter the n- or p- doped regions, where they experience an effective, charge-density dependent mean field shift $\Delta E_P \sim g \cdot \sigma(x)$. The proportionality constant $g$ is the empirically determined exciton-electron coupling strength. The steep charge density gradient (see upper panel of Fig. 3, broken line) applies a restoring force on the excitons, leading to a tightly confining repulsive potential even for exciton energies larger than the free, zero-momentum, exciton energy ($E_{x0}$).

The total potential for excitons in the p-i-n configuration,

$$V(x) = -\frac{1}{2}\alpha F_x(x)^2 + g \cdot \sigma(x), \qquad (1)$$

is the sum of the dc Stark shift and repulsive polaron shift contributions. This potential provides confinement only for neutral excitons, whereas charged species like unbound electrons or holes experience a repulsive potential that accelerates them towards the n-and p-doped regions, respectively. The exciton confinement strength achieved with such a potential depends on the geometry of the device and the excitonic properties of the material.

For the simulation in Fig. 3, the potential shape was calculated using the following parameters: $\alpha$ = 6.5 eV nm$^2$/$N^2$(for MoSe$_2$), $mx$= 1.3 $m_e$, $g$ = 1.3 $\mu$eV$\mu$m$^2$, and hBN thickness of 30 nm. The lower panel of Fig. 3 shows the resulting overall potential (upper broken line) and the dc Stark contribution (lower broken line) using the in-plane electric field and charge density distribution obtained for bottom gate voltage $V_{BG}$ = 4.5 V and top gate voltage $V_{TG}$ = -7 V. Interestingly, at large charge densities ($\sigma \gtrsim 10^{12}$ cm$^{-2}$), the polaronic confinement is almost a factor of 3 larger than the dc Stark shift confinement. The discrete eigenstates in the confining potential have a level separation $\hbar w_x \approx 1$ - 1.5 meV ($\ell \approx 6$ - 8 nm), which is on the order of the 2D exciton radiative linewidth $\Gamma$.

## First embodiment of device

A vdW heterostructure device was fabricated, implementing the concept elaborated above. The device comprised a semiconductor layer in the form of a MoSe$_2$ monolayer (1L) flake, encapsulated by ~ 30 nm thick hBN flakes acting as the bottom and top spacer layers, on which gold BG and TG electrodes were disposed. Details of device fabrication are described below.

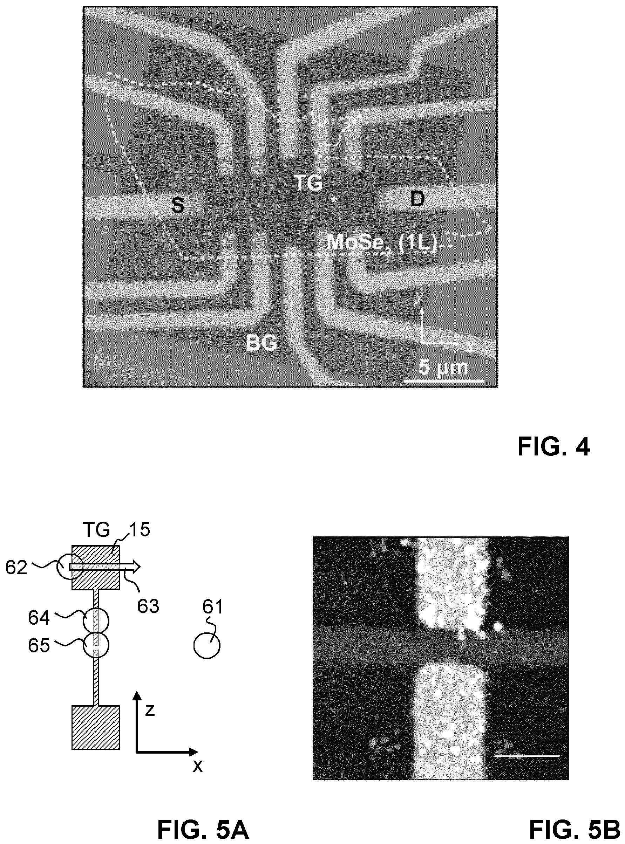

An optical micrograph of the resulting heterostructure is shown in Fig. 4. The BG electrode was comparatively large, encompassing almost the entire MoSe$_2$ flake. The TG electrode took the shape of a narrow strip extending along the y direction. The TG electrode was optically transparent, allowing to probe optical properties in the region underneath the gate and along its edge.

The shape of the TG electrode is illustrated in more detail in Fig. 5A. A 100 nm wide gap in the TG electrode was created. This gap can be clearly seem in Fig. 5B. The TG electrode was contacted from both sides of the gap to have the same electric potential on both sides.

The semiconductor layer was contacted by several palladium contacts. Some of these contacts were used for doping the semiconductor layer by applying voltages between the BG and TG electrodes and the semiconductor layer. Two of the contacts near opposite ends of the semiconductor flake along the x direction acted as source (S) and drain (D) contacts for studying charge transport along the x direction.

The global doping level was tuned by applying a BG voltage between the BG electrode and the semiconductor layer. The charge carrier density underneath the TG electrode was modified by applying a TG voltage between the TG electrode and the semiconductor layer. By applying voltages of opposite polarity to the TG and BG electrodes, it was possible to simultaneously generate p- and n-doped regions in the semiconductor layer, separated by an i-region.

Reflectance spectra away from top gate

To study the optical properties of the sample at liquid helium temperature, broadband reflectance and photoluminescence (PL) spectroscopy was performed through a high numerical aperture lens focused at different positions on the sample.

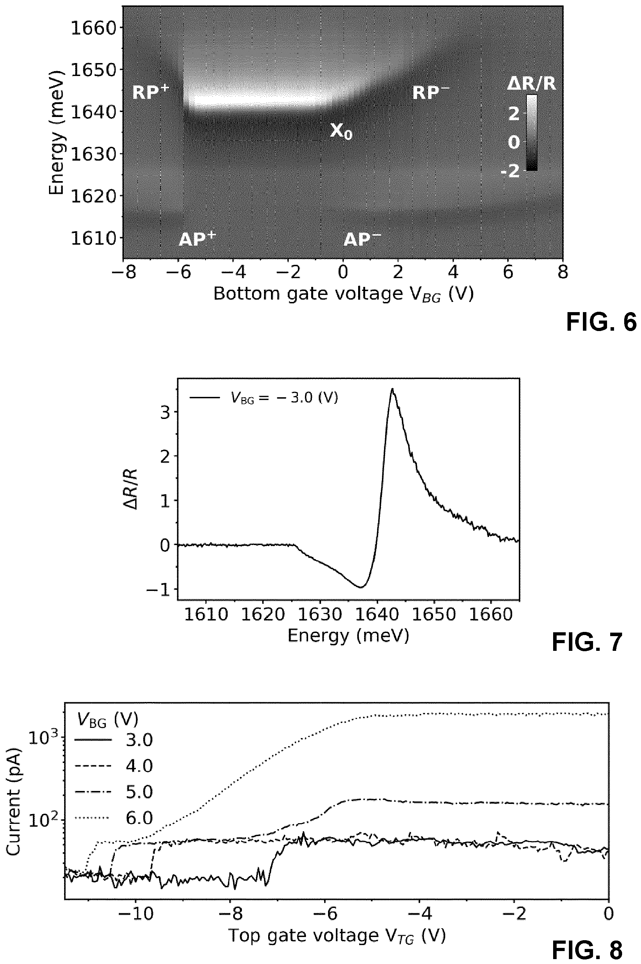

In Fig. 6, typical reflectance spectra as a function of $V_{BG}$ taken at a position away from the TG are shown. The beam spot position is marked with a star-symbol in Fig. 4 and is indicated as position 61 in Fig. 5A. In this position, the doping characteristics of the semiconductor layer are expected to be determined by the BG voltage only, while the effects of the TG voltage are expected to be negligible.

The spectra indicated that a charge neutral regime exists (-5.5 V $\lesssim V_{BG} \lesssim$ -0.5 V), where no significant doping of the semiconductor layer occurs. A typical spectrum for the reflectance change ΔR/R in this regime is shown in Fig. 7 (for $V_{BG}$ = -3.0 V). The neutral exciton transition was identified at $E_{x0}$= 1642 meV. As the monolayer was globally n-doped with electrons ($V_{BG}$ > -0.5 V) or p-doped with holes ($V_{BC}$ < -5.5 V), the dressing of the excitons by itinerant charges led to the emergence of attractive and repulsive polaron states as shown.

In addition to optical spectroscopy, source-drain transport measurements were performed in the n-doped regime, particularly to characterize the influence of the TG geometry on electronic properties of the semiconductor. In Fig. 8, the source-drain (S-D) current through the channel below the split top gate is shown as a function of $V_{TG}$ for different Fermi energies set by $V_{BG}$ and fixed S-D voltage $V_{SD}$ = 2 V. The fact that the 100 nm wide channel can be completely pinched off at a certain $V_{TG}$ demonstrates that a region of width ~ 50 nm around the TG can be completely depleted of electrons. As expected, for larger $V_{BG}$, corresponding to larger global Fermi energy, the channel pinch-off occurs at more negative $V_{TG}$. As the channel is opened by increasing $V_{TG}$, a non-linear steplike increase in the current was observed, indicating strong electron confinement in the transverse (y) direction of the mesoscopic 1D channel.

Confinement of excitons along the top gate

In order to study the modification of excitonic states due to confinement in the narrow depleted region around the TG as discussed above, the optical response of the TMD monolayer was measured by positioning the beam spot on the edge of the TG. This position is indicated in Fig. 5A as position 62.

Due to the diffraction-limited spot size, the measurements corresponded to the combined optical response of three distinct spatial regions: (I) the n-doped region away from the TG that is affected only by the BG, (II) the p-doped region directly underneath the TG, and (III) the narrow i-region between I and II. The contribution of region I to the total optical response remains unchanged as $V_{TG}$ is varied. Therefore, to discern the influence of the TG alone, $V_{TG}$-dependent spectra for fixed values of $V_{BG}$ were measured, and the reflectance spectrum obtained for $V_{TG}$ = 0 V was subtracted from the total signal to obtain the normalized differential reflectance,

$$\frac{\Delta R}{R} = \frac{R(V_{TG}) - R(V_{TG} = 0)}{R(V_{TG} = 0)} . \quad (2)$$

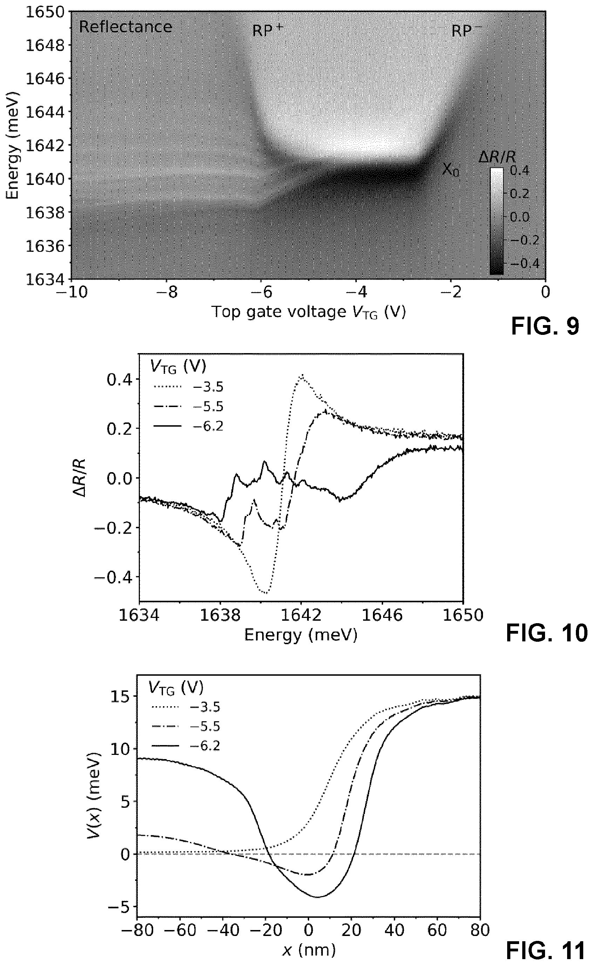

In Fig. 9, normalized $\Delta R/R$ is presented as a function of $V_{TG}$ at fixed $V_{BG}$ = 4 V. The typical doping-dependent optical response from region II directly underneath the TG can be clearly seen, which is similar to Fig 6. This includes a neutral regime (Xo: -6 V $\lesssim V_{TG} \lesssim$ -3 V) flanked by repulsive polaron branches on the electron (RP$^-$: $V_{TG} \gtrsim$ -3 V) and hole (RP$^+$: $V_{TG} \lesssim$ -6 V) doped sides. Interestingly, the fact that a hole-side repulsive polaron branch RP$^+$ can be observed shows that, when region I is electron-doped, hole doping of region II is possible even without direct electrical contacts. Without wishing to be bound by theory, it may be speculated that this may be an optical doping effect stemming from exciton-dissociation.

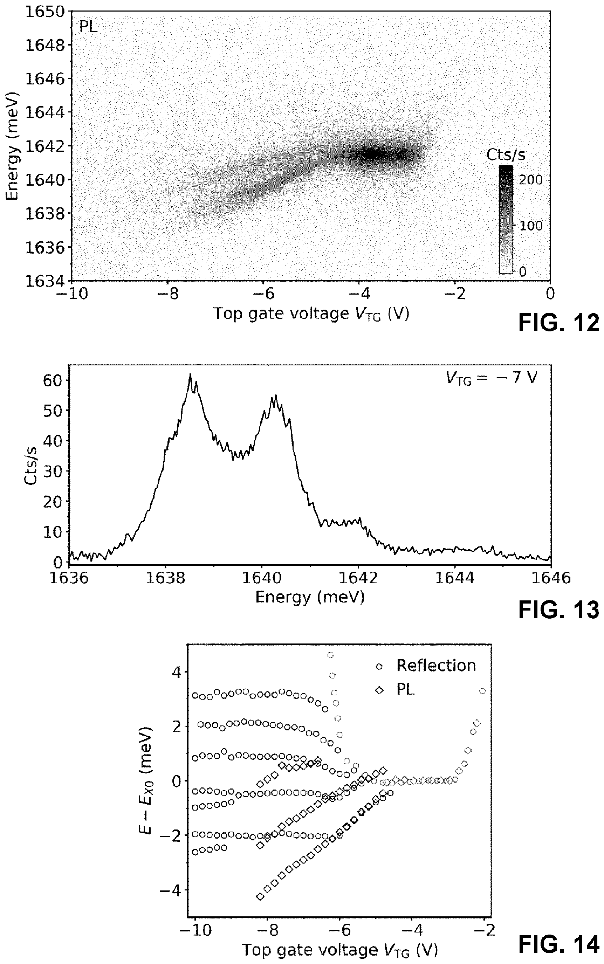

In addition to the expected optical response, we observe a plethora of narrow and discrete spectral lines on the hole-doped side for $V_{TG} \lesssim$ -4 V, which emerge from the 2D exciton and repulsive polaron continuum and red shift with decreasing $V_{TG}$. These narrow spectral lines were consistently found at all beam spot positions investigated along the edge of the TG, but disappear when the beam spot moves away from the TG edge. PL measurements at the same position on the sample, shown in Fig. 12, also reveal red shifting discrete emission lines similar to the reflectance spectra. The PL spectrum at $V_{TG}$ = -7 V is shown in Fig. 13, which show a series of four lines that become monotonously weaker with increasing energy. As a function of $V_{TG}$, the PL counts of each line also decreased with more negative voltage, ultimately becoming too weak to discern for $V_{TG}$ < -9 V.

In Fig. 10, spectral linecuts taken at $V_{TG}$ = -3.5 V, -5.5 V and -6.2 V are shown, which exemplify the appearance of new states below the continuum as the voltage is decreased. For reference, estimates of the corresponding potential (V(x), Eq.(1)) for those voltages as obtained from electrostatic simulations are shown in Fig. 11.

The discrete lines were analysed by fitting a superposition of Lorentzian functions to the reflectance spectra. The resonance frequencies of the discrete states in reflectance (circles) and PL (diamonds) thus obtained are plotted in Fig. 14. The fits reveal a level separation $\hbar w_x \sim$ 1.5 meV between the lowest two states at $V_{TG}$ = -6 V. Furthermore, the lowest energy state in reflectance shows a minimum linewidth of $\Gamma \sim$ 300 $\mu$eV, which is more than an order of magnitude narrower than the linewidth of the unbound 2D exciton $X_0$ ($\Gamma \sim$ 4 meV in Fig. 6) away from the TG. Interestingly, additional fine structure of some of the discrete states at a $V_{TG} \lesssim$ -8 V was observed, the origin of which is not currently understood.

The emergence of the discrete lines from the 2D continuum can be attributed to the quantization of motional states of excitons due to strong confinement in the direction perpendicular to the gate edge. The level separations observed in the experiment are of the same order as those obtained from the electrostatic simulations of the device (lower panel of Fig. 3). The lowest energy narrow resonances that red shift with decreasing $V_{TG}$ are fully consistent with the presence of an attractive potential due to dc Stark effect that lowers the neutral exciton energy in a spatially dependent way. Further evidence for confinement is provided by the dramatic reduction of the linewidth of the individual states compared to the free exciton. This is expected to stem from two factors: (i) reduced radiative decay of 1D excitons as compared to their 2D counterparts, and (ii) lower inhomogeneous broadening as the exciton motion is restricted to a smaller spatial area due to confinement. In addition, the reduced electron-hole wavefunction overlap originating from the permanent in-plane electric dipole moment induced by the in-plane electric field should result in a further reduction of the radiative decay rate.

Remarkably, also quantized modes with energy higher than the 2D exciton energy $E_{X0}$ were observed, which split from the repulsive-polaron branch of the p-doped region (RP$^+$). Without wishing to be bound by theory, it may be speculated that these resonances are due to the additional exciton confinement due to repulsive exciton-charge interactions in the neighboring n- and p-doped regions (see the second term in Eq. (1)). This interaction-induced polaronic confinement is in fact dissipative in nature due to the non-radiative decay of repulsive polarons into the lower attractive branch, the rate of which increases with charge density. Specifically, the dissipation arises from the spatial component of the excitonic wavefunction which leaks into the charged regions. As a consequence, the linewidth of the confined states increases up the ladder of states, accompanied by a loss of oscillator strength. It is believed that this is the first example of a trapping mechanism that relies on many-body interactions between a mobile impurity and a surrounding medium. Understanding the dynamics of excitons in such non-Hermitian confining potentials constitutes an interesting problem for future investigations.

A comparison of the reflectance and PL measurements (Fig. 14) reveals a pronounced discrepancy in the voltage dependence of confined exciton resonances for $V_{TG} \lesssim$ -6 V. In the regime -6 V < $V_{TG}$ < -4 V, where the area under the gate is still mostly undoped, the reflectance and PL lines shift with the same slope, and both measurements show agreement with simulations. This changes at the onset of strong hole-doping under the gate at $V_{TG} \approx$ -6 V, which is evidenced by a change in the slope of the repulsive polaron resonance in Fig. 9. Whereas the PL lines continue to red shift almost linearly with $V_{TG}$, the reflectance lines show an abrupt change in slope particularly at the lowest energies. The difference between the reflectance and PL lines scales linearly with the Fermi energy. The origin of this striking discrepancy is currently unknown. However, it may be speculated that the interactions between the dipolar excitons in the i-region and the free carriers in the neighboring n- and p-doped regions, inducing a repulsive dressing of the excitons, could provide an explanation. While absorption or reflectance measurements probe the high energy eigenstates with a sizeable bare exciton (quasiparticle) weight, PL originates from a nonequilibrium process consisting of phonon-mediated relaxation of high-energy carriers and subsequent fast decay of localized excitons; this two-step process may be completed before a screening cloud in the neighboring layers could be formed.

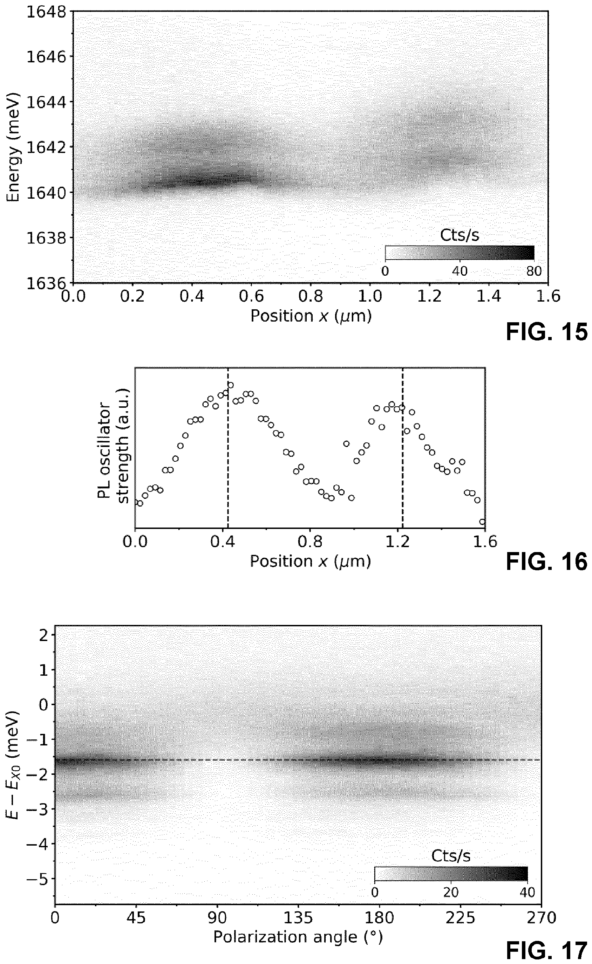

To provide further evidence that the observed confined states are localized in the i-regions parallel to the edge of the TG, PL was measured at a fixed $V_{TG}$ = -6 V while scanning the position of the beam spot across the TG along the x direction, as illustrated by arrow 63 in Fig. 5A. In this manner, PL was measured at different points close to a 1 $\mu$m wide segment of the TG. Since this width is larger than the optical resolution, the PL signals coming from the two edges of the TG could be separated. The results are illustrated in Fig. 15. Moving from one side of the TG to the other, the discrete PL lines appeared as the beam spot crossed the first edge, almost vanished when the beam spot was entirely on the TG, and reappeared as the beam spot crossed the second edge. In the regions away from the edge, the PL oscillator strength was mainly carried over to the attractive polaron branch. In Fig. 16, the oscillator strength of the lower emission line is shown as a function of space, which shows two peaks separated by about ~ 800 nm, in good agreement with the width of the gate when taking into account the measurement uncertainties.

Polarization of light emitted by photoluminescence

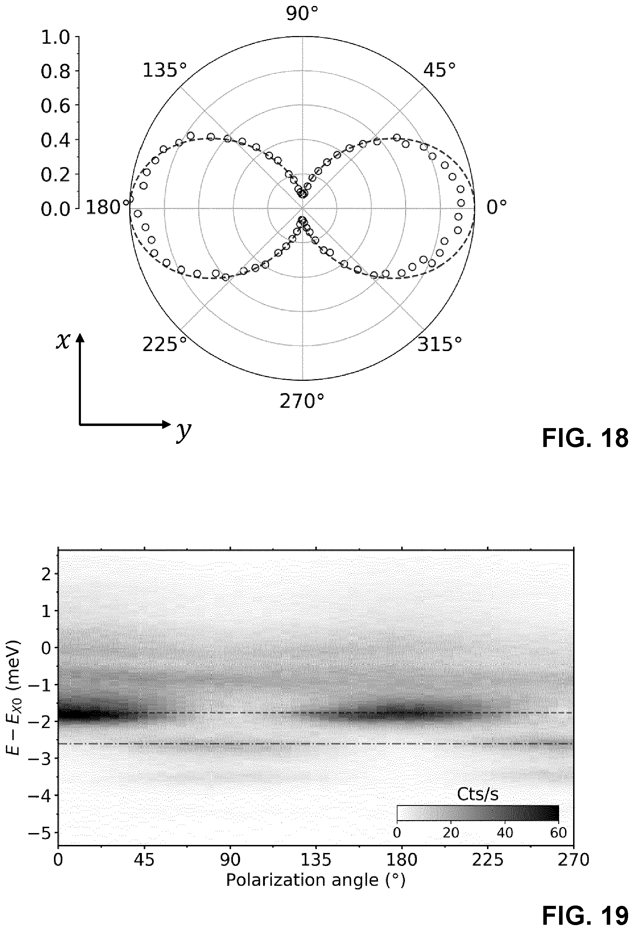

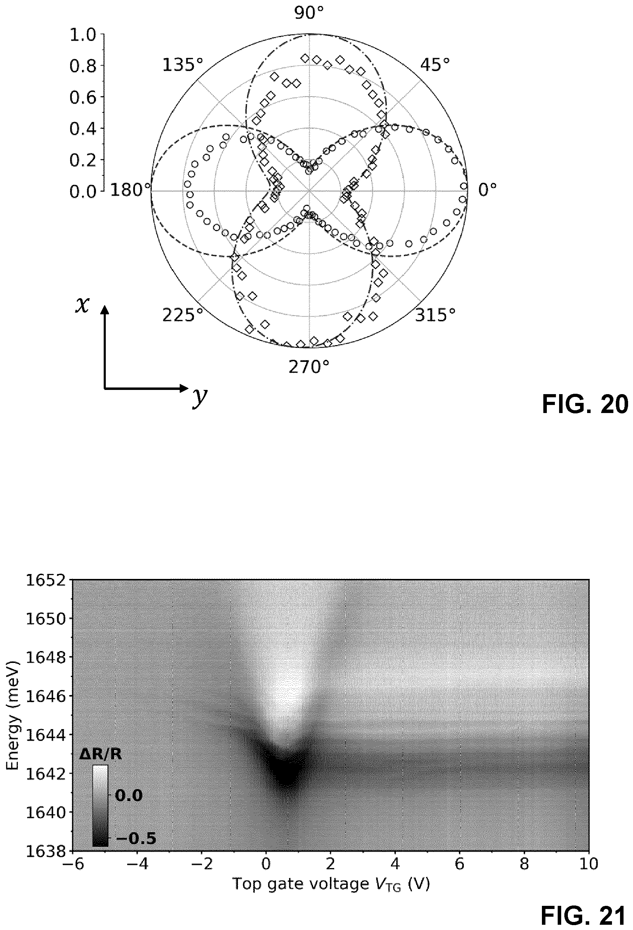

It is well known that emission from strongly confined excitons in 1D semiconductor wires is polarized along the wire axis. To obtain confirmation of the 1D nature of the narrow resonances visible in Fig. 9, their polarization properties were determined. Figs. 17-20 show linear polarization resolved PL measurements taken at two positions on the sample: Fig. 17 depicts PL from a region which encompasses two parallel TG edges, shown as region 64 in Fig. 5A. Fig. 19, on the other hand, shows PL obtained by aligning the beam spot on the split gate (region 65 in Fig. 5A), which contains two sets of orthogonal wire segments. In both measurements, the PL emission from confined exciton states exhibited a high degree of linear polarization $\xi = (I_{max}-I_{min})/(I_{max}+I_{min})$, where $I_{max}$ and $I_{min}$ are maximum and minimum intensities in the polarization scan. At $V_{TG}$ ~ -6 V, typical values of $\xi \approx 0.8$ were measured, and a maximum value at some positions of $\xi_{max} \approx 0.96$. This high degree of linear polarization is comparable to what was previously reported in other 1D systems, such as semiconductor nanowires, carbon nanotubes, and 1D moire excitons. Whereas in Fig. 17, the PL lines are polarized only along y, additional sets of x-polarized lines were observed in Fig. 19, which arise from the 1D exciton wires in the gap region that are oriented along x. In Fig. 18 and 20, the 0° angle of the polar plots is set to the primary polarization axis, which aligns with the wire axis in y-axis within experimental uncertainties of $\pm 5°$. By analyzing the polarization properties of exciton and polaron resonances from regions I and II, it was confirmed that the high degree of polarization is unique to the confined states, whereas all other resonances exhibit low polarization degree ($\lesssim 0.2$) in randomly oriented directions consistent with typical strain found in vdW heterostructures.

Strongly polarized emission originates from the long-range electron-hole Coulomb exchange in excitons, which results in a coupling between the valley degree of freedom and the center-of-mass exciton motion. In fact, this coupling can be orders of magnitude greater in TMD monolayers than in III-V semiconductors due to the much larger exciton binding energy in the former. For momenta exceeding the light cone, the long-range electron-hole exchange coupling leads to an energy splitting between longitudinal and transverse electromagnetic modes. When confinement is introduced, the anisotropy of the 1D potential breaks the rotational symmetry and acts as an in-plane Zeeman field on the valley pseudospin, which in turn opens a gap between parallel and perpendicular polarizations even at for momenta within the light cone. This leads to measurable signatures in the polarization properties of emission. In the investigated system, the localization length scale in the transverse direction ($\ell \sim 7$ nm) is two orders of magnitude smaller than the wavelength of light, which leads to substantial gap between $x$ and $y$ polarization components.

n-i-p regime

The above embodiments established a "p-i-n regime", where region I was n-doped and region II was p-doped. However, the mechanism of quantum confinement in the i-region works the same way even in the opposite "n-i-p regime" where region I is p-doped and region II is n-doped. In Fig. 21, the normalized reflectance measured as a function of $V_{TG}$ for fixed $V_{BG}$ = -8 V is shown. This measurement was performed at a position on the sample where the TG was 200 nm wide, similar to Fig. 9. Similar qualitative signatures of quantum confinement were observed, i.e. the narrow discrete lines emerging out of the repulsive polaron continuum. As expected, these lines now appear at positive $V_{TG}$. Some quantitative differences were found between the p-i-n and n-i-p settings. In particular, a prolonged neutral region, as seen in Fig. 9, is absent in the data shown in Fig. 21. The origin of this discrepancy is currently not understood.

Confinement without doping

While in the above examples, exciton confinement was achieved by creating a p-i-n or n-i-p heterostructure comprising p- and n-doped regions separated by an i-type region, p- or n-doping is actually not required for achieving confinement. It suffices to generate a strongly inhomogeneous in-plane electric field having a local maximum.

This is illustrated in Figs. 22-27. Each of these figures shows, in the respective upper panel, the magnitude of charge density $|\sigma|$ (dash-dotted line) and of the in-plane electric field $F_x$ (dotted line) as a function of the x position. The BG voltage $V_{BG}$ was kept at a fixed bias of 4.5 V, while the TG voltage $V_{TG}$ was varied from -2 V to -7 V in steps of 1 V.

Three distinct regimes can be identified as $V_{TG}$ is varied, which can be classified according to the doping state in regions I, II and III.

For $V_{TG}$ > -4 V, we are in the n-n-n regime, where all three regions are n-doped, but there is a spatial variation of electron density. This is shown in Figs. 22 and 23.

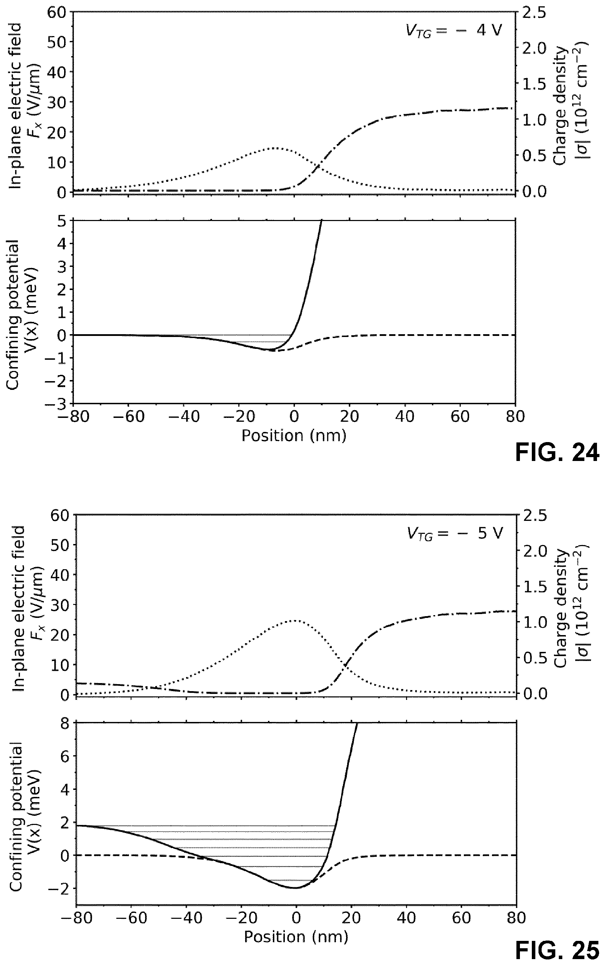

As $V_{TG}$ is decreased, regions II and III are depleted completely of charge carriers, and hence we are in the i-i-n regime, which is accompanied by a large increase in magnitude of the in-plane electric field $|F_x|$. This is illustrated in Fig. 24. While the maximum of the field distribution is located close to the top gate edge, owing to the large lateral extent of the neutral region, the in-plane field persists even under the TG and exhibits a spatial asymmetry.

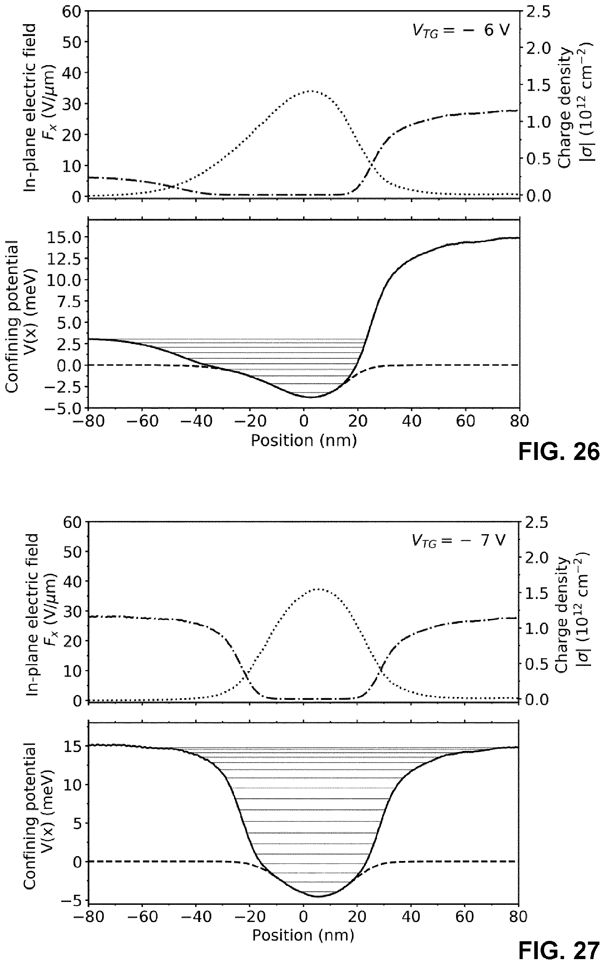

The i-i-n regime persists until the onset of hole-doping in region II, which occurs in the simulations at $V_{TG}$ = -5 V (see Fig. 25). As hole-doping starts, only a narrow ∼ 30 - 40nm wide neutral i-region remains, located at the edge of the TG and flanked by a steep increase in charge density. This is the p-i-n regime. As a consequence, the in-plane field distribution also becomes concentrated in this narrow region due to screening in the neighboring charged areas. Lowering $V_{TG}$ further pushes the neutral junction region further away from the TG, thereby making the electric field distribution increasingly symmetric (see Figs. 26 and 27). Ultimately, at $V_{TG}$ = -10 V (not illustrated), an in-plane electric field peaking at 55 V/$\mu$m is obtained.

The resulting potential experienced by the exciton in its center-of-mass frame for various $V_{TG}$ is depicted in the lower panel of each of Figs. 22-27. Additionally, whenever appropriate, also the numerically calculated discrete eigenstates associated with the confining potential are shown. Importantly, a potential well in close proximity to the TG edge starts to form already at $V_{TG}$ = -4 V, in the i-i-n regime. This potential well supports two discrete bound eigenstates (Fig. 23). The continuum is given by the 2D free exciton energy $E_{X0}$ and the confinement is solely driven by the dc Stark shift. As the gate voltage is lowered further to $V_{TG}$ < -5 V, we enter the p-i-n regime (Figs. 25-27), where the continuum is solely determined by the hole or electron RP energy, depending on which charge has lower density. For example, for $V_{TG}$ < -7 V, the hole density exceeds the electron density, which leads to a shifting of the continuum from the hole RP to the electron RP. This repulsive polaron shift leads to the striking observation of quantized states above the free exciton energy $E_{X0}$.

The simulations on Figs. 22-27 show that a confining potential can already be formed in the i-i-n regime, where confinement is solely caused by the dc Stark shift in the inhomogeneous in-plane field, while the repulsive polaron shift due to a spatial modulation of charge density does not yet contribute to confinement.

This finding is supported by the experimental data in Fig. 9, where resonances from discrete eigenstates can be seen already in the neutral regime.

## Alternative arrangements of the BG and TG electrodes

In the exemplary embodiment of Fig. 4, the BG electrode 13 covered almost the entire bottom of the semiconductor layer 11, while the TG electrode 15 was structured and partially overlapped with the BG electrode. However, many other electrode arrangements are possible. In particular, the BG electrode may also be structured.

While a partial overlap of the BG and TG electrodes is advantageous for defining a particularly narrow neutral region between the n- and p-doped regions without requiring lateral alignment of the gate electrodes on a nanometer scale, a partial overlap is not always required. In the absence of an overlap, it is also conceivable to arrange two gate electrodes in a common plane above or below the semiconductor layer, and to supply different gate voltages between these gate electrodes and the semiconductor layer. In this manner, many different geometries of the TG and GB electrodes can be realized.

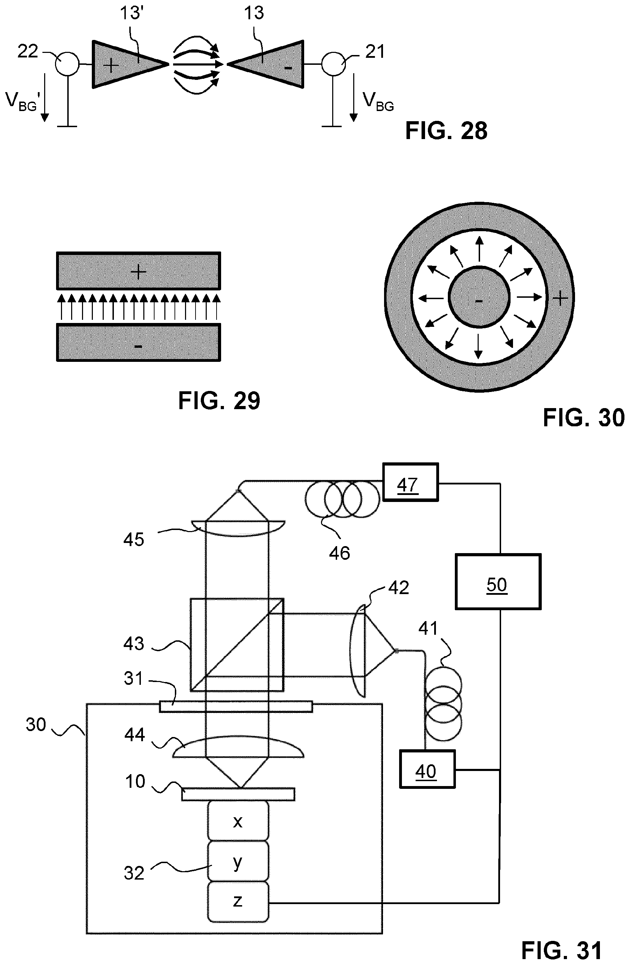

Some possible geometries are illustrated in Figs. 28 to 30. Fig. 28 shows a possible arrangement of gate electrodes 13, 13' for forming a quantum dot. Each gate electrode defines a sharp tip when viewed along a direction perpendicular to the device plane, the tips being arranged opposite to each other. Gate voltage sources 21, 22 may provide these electrodes with different voltages $V_{BG}$ and $V_{BG}$' relative to the semiconductor layer 11 to create an electric field having a strongly inhomogeneous in-plane component. In this manner, neutral excitons can be confined in zero dimensions in the region between the tips of the gate electrodes. In addition, by providing sufficiently high voltages with opposite signs, a p-doped region may be created below one of the gate electrodes and an n-doped region below the other gate electrode, the p- and n-doped regions being separated by an i-type region, and the resulting polaron shift may enhance confinement.

The gate electrodes 13, 13' may be arranged in a common plane below the semiconductor layer 11, forming two separate bottom gate electrodes. Alternatively, they may be arranged in a common plane above the semiconductor layer 11, forming two separate top gate electrodes. In both these cases, a further gate electrode may be arranged on the opposite side of the semiconductor layer, e.g., to globally modify the charge carrier density. In yet other embodiments, the gate electrodes 13, 13' may be arranged on opposite sides of the semiconductor layer, allowing their in-plane distance to be minimized.

Fig. 29 shows a possible arrangement of gate electrodes for confining dipolar in-plane excitons in a 1D channel, and Fig. 30 shows a possible arrangement of gate electrodes for confining dipolar in-plane excitons in an annular region. Again, the gate electrodes may be supplied with voltages of different polarities to create strongly inhomogeneous in-plane fields, and optionally to create n- and p-doped regions below the gate electrodes. Again, the gate electrodes may be provided in a common plane on one side of the semiconductor layer, or they may be provided on different sides of the semiconductor layer.

Further modifications

While $MoSe_2$ were used in the above example as the material for the semiconductor layer, other materials may also be used. While transition metal dichalcogenides are preferred, other classes of layered semiconductor materials may also be used. These include inorganic and organic hybrid perovskites, black phosphorous, bilayer graphene, silicene, antimonene, and some semiconducting polymers.

While in preferred embodiments the semiconductor layer is a monolayer, this is not strictly required. The semiconductor layer may be comprised of more than one layer as long as the semiconductor layer is sufficiently thin.

If spatially indirect excitons are to be confined, the layer structure 11 may comprise two or more thin semiconductor layers separated by a separating layer.

Device fabrication

The device shown in Fig. 4 was fabricated as follows. Device fabrication began by mechanically exfoliating $MoSe_2$ and hBN flakes from bulk crystals (HQ Graphene $MoSe_2$ and NIMS h-BN) onto 285 nm $SiO_2$ substrates using wafer dicing tape (Ultron). The flake thicknesses were identified using optical contrast measurements and/or atomic force microscopy. For the device of Fig. 4, hBN flakes which are ~ 30nm thick were selected. Embedded Via-contacts were formed by etching holes in the hBN spacer layers by means of electron beam lithography and reactive ion etching (Oxford Plasmalab 80Plus). The etching conditions were the following: $CHF_3$:$O_2$ 40:4 sccm gas mixture, 60 W RF power and 40 mTorr gas pressure. To ensure a smooth bottom surface for the subsequent metal evaporation in the holes, the etched hBN layer was transferred to a new $Si/SiO_2$ substrate using a standard dry polymer transfer method (also used for stacking, see following paragraph). Next, the pre-defined holes were filled with metal by performing a second lithography step and (electron-beam) evaporation of 20 nm of Pd and 30 nm of Au. The multilayer stack was then created by picking up the top hBN layer with embedded Via-contacts and laminating it onto a monolayer $MoSe_2$, and a bottom hBN flake using the aforementioned dry transfer process.

For the dry transfer of flakes, a glass slide was used, onto which a hemispherical polydimethylsiloxane (PDMS) stamp was attached. This stamp was covered with a thin layer of polycarbonate (PC), allowing the sequential pickup of the flakes. All stacking steps were thereby performed in an inert Ar atmosphere inside a glovebox and at a temperature of 120 °C. The finished stack was deposited onto the gold bottom gate by increasing the temperature up to 150 °C, which allowed the PC to delaminate from the PDMS and to be released on the substrate. By further heating to 170 °C, the PC was torn at the edges. The PC was dissolved by immersing the substrate in chloroform.

The bottom gate on the $Si/SiO_2$ substrate was formed by lithographically defining a square of 20 $\mu$m size and electron-beam evaporating 3 nm of Ti and 10 nm of Au.

Subsequently, a split top gate electrode was patterned, which was 200 nm wide and included a 100 nm gap, allowing the formation of a gate-defined constriction. For this electron-beam lithography was used to evaporate 3 nm of Ti and 10 nm of Au. This rendered the top gate optically transparent and therefore allowed to probe the optical properties of the monolayer underneath. Finally, the embedded Via-contacts in the top hBN spacer layer along with top gate were electrically contacted with extended metal electrodes prepared using another lithography step and subsequent evaporation of 5 nm of Ti and 85 nm of Au.

For more information about the methods employed for fabrication of the device and possible alternative methods, see C. Tan et al., "Recent advances in ultrathin two-dimensional nanomaterials", Chemical Reviews 117.9 (2017): 6225-633, in particular, section 4.1, F. Pizzocchero et al., "The hot pick-up technique for batch assembly of van der Waals heterostructures", Nat. Commun. 7, 11894 (2016), and R. Frisenda et al., "Recent progress in the assembly of nanodevices and van der Waals heterostructures by deterministic placement of 2D materials", Chemical Society Reviews 47, 53-68 (2018). For the fabrication of the electrical contacts, see Y. Jung et al., "Transferred via contacts as a platform for ideal two-dimensional transistors", Nat. Electron. 2, 187-194 (2019).

It must be emphasized that ultrathin semiconductor layers as well as dielectric insulating layers may be obtained not only by cleavage from a bulk crystal, but also by other methods such as chemical vapor deposition, see, e.g., the paper by C. Tan et al., section 4.7, and that the present invention is not limited to devices fabricated by the above-described methods.

## Experimental setup

Optical experiments were carried out in a confocal microscope setup, as schematically illustrated in Fig. 31. The sample was mounted on an xyz piezo-electric stage 32 located inside a stainless steel tube 30, which was immersed in a liquid helium bath cryostat. The steel tube 30 was filled with 20 mbar helium exchange gas to maintain a sample temperature of ∼ 4.2 K. Free-space optical access to the sample was enabled through a glass window 31 on top of the tube 30. White light (WL) reflectance and photoluminescence were measured using a broadband light-emitting diode centered at 760 nm and a tunable single-mode Ti:Sapphire laser as the excitation light source 40, respectively. The light from the source was coupled into an optical fiber 41. At the end of the fiber, a beam was formed by a lens arrangement 42. The beam was focused to a diffraction-limited spot through a high numerical aperture lens 44 (NA = 0.68). The light reflected / emitted from the sample was then collected using the same lens, separated from the incident light by a beam splitter 43, coupled into a single-mode fiber 46 using a lens arrangement 45 and imaged on a spectrometer 47 equipped with a liquid-nitrogen-cooled charge-coupled-device (CCD). The excitation light source 40, the spectrometer 47, and the xyz stage 32 were controlled by control circuitry 50. For WL measurements an excitation power of a few tens of nW, and for PL a few $\mu$W was maintained. The polarization resolved PL measurements were carried out with an angle-scanning polarizer placed in the emission path.

## Electrostatic simulations

The position and voltage dependence of both the charge density and in-plane electric field were investigated by performing finite-element calculations with the "Semiconductor" package in COMSOL. These quantities were determined by solving drift-diffusion equations coupled with Poisson's equation. The bottom gate was kept at a fixed bias of 4.5 V and ensured a global electron doping throughout the semiconductor. The voltage on the top gate was varied from -2V to -10V. The material parameters assumed for this calculation are a bandgap of 2 eV, an electron / hole effective mass of $m_{eff}$= 0.6 $m_e$, an out-of-plane dielectric constant $\varepsilon\perp$ = 7.2, and an in-plane dielectric constant $\varepsilon_{\parallel}$ = 16 for the semiconductor. For hBN we neglect the difference between in- and out-of-plane dielectric constants and assume a value of 4.6. Furthermore, in order to achieve convergence, the simulation temperature is increased to 350K and a finite thickness of 5nm is assumed for the semiconducting TMD layer. The relevant electrostatic quantities are then extracted as measured in the middle of this layer. We emphasize that COMSOL's "Semiconductor" package assumes a 3D density of states for the charges in the system. Hence, we consider our simulations rather to provide a ballpark estimate of the important electrostatic quantities.

## Summary and outlook

In summary, strong confinement of excitons was demonstrated on length scales much smaller than the size of the gate electrodes. For future devices, this method may provide several crucial advantages over alternative approaches that use material modulation: (i) deterministic positioning of tailor-made potentials can be achieved by suitable design of electrodes; (ii) electrical tunability of exciton resonance energy may allow to overcome disorder to create multiple identical emitters; (iii) the quantum confinement is achieved while leaving the semiconductor pristine; and (iv) quantum confinement of in-plane direct excitons, as opposed to layer-indirect excitons, allows stronger coupling to light.

Several applications are possible. First and foremost, strong confinement of excitons with a permanent dipole moment perpendicular to the wire axis is expected to strongly enhance exciton-exciton interactions while allowing for hybridization with a microcavity-mode; consequently, a 1D wire is expected to strongly couple to a cavity mode, which may emerge as a building block of a strongly interacting photonic system. Even in the absence of cavity-coupling, strong interactions could enable the realization of an excitonic Tonks-Girardeau gas with photon correlations providing signatures of fermionization. Second, the proposed method can be straightforwardly applied to achieve lower dimensional quantum confined structures such as quantum dots or quantum rings using proper design of electrodes.

**Claims**

1.   A method for laterally confining neutral excitons in a semiconductor layer structure (11) of a solid-state device (10), the semiconductor layer structure (11) comprising at least one semiconductor layer and defining a device plane, the method comprising:

   creating an inhomogeneous electric field (F) in the semiconductor layer structure (11), the electric field (F) having an in-plane field component ($F_x$) whose magnitude varies along at least at least one confinement direction (x) in the device plane, the magnitude of the in-plane field component ($F_x$) having a maximum along said confinement direction (x), whereby a lateral confining potential (V(x)) for neutral excitons is caused around the maximum; and

irradiating the solid-state device (10) with light to create neutral excitons in the semiconductor layer structure (11), the neutral excitons being laterally confined along the confinement direction (x) by the lateral confining potential (V(x)).

**2.** The method of claim 1,
wherein creating the inhomogeneous electric field (F) in the semiconductor layer structure (11) comprises modifying a charge carrier density ($\sigma$) in the semiconductor layer structure (11) to create a p-doped region (16) and/or an n-doped region (18),
wherein preferably both a p-doped region (16) and an n-doped region (18) are created, the p-doped region (16) and the n-doped region being laterally separated in the device plane by an i-type region (17), the maximum of the magnitude of the in-plane field component ($F_x$) being located in the i-type region (17) between the p-doped region (16) and the n-doped region (18), whereby the neutral excitons are laterally confined in the i-type region (17).

**3.** The method of claim 2, wherein modifying the charge carrier density ($\sigma$) in the semiconductor layer structure (11) comprises at least one of:

chemical doping of at least a portion of the semiconductor layer structure (11); and
applying at least one gate voltage between at least one gate electrode (13; 13'; 15) and the semiconductor layer structure (11).

**4.** The method of any one of the preceding claims,
wherein the solid-state device (10) comprises an insulating first spacer layer (12) disposed on a first surface of the semiconductor layer structure (11) and a first gate electrode (13) arranged on the first spacer layer (12), and
wherein creating the inhomogeneous electric field (F) comprises applying a first gate voltage ($V_{BG}$) between the first gate electrode (13) and the semiconductor layer structure (11).

**5.** The method of claim 4,
wherein the solid-state device (10) further comprises a second gate electrode (15) arranged on the first spacer layer (12) or on an insulating second spacer layer (14), the second spacer layer (14) preferably being disposed on a second surface of the semiconductor layer structure (11) opposite to the first spacer layer (12),
wherein creating the inhomogeneous electric field (F) in the semiconductor layer structure (11) comprises applying a second gate voltage ($V_{TG}$) between the second gate electrode (15) and the semiconductor layer structure (11), the first and second gate voltages ($V_{BG}$, $V_{TG}$) having opposite signs,
wherein preferably the second gate electrode (15) is arranged on the second spacer layer (14) and partially overlaps with the first gate electrode (13) when viewed along an out-of-plane direction (z) that is perpendicular to the device plane.

**6.** The method of any one of the preceding claims,
wherein the maximum of the magnitude of the in-plane field component ($F_x$) is at least 10 V/$\mu$m, and/or
wherein the in-plane field component ($F_x$) as a function of position (x) along the confinement direction describes a curve having a full width at half maximum (FWHM) of not more than 100 nm.

**7.** The method of any one of the preceding claims, wherein the at least one semiconductor layer in the semiconductor layer structure (11) has a thickness that causes electric polarizability of excitons perpendicular to the device plane to be not more than 10% of electric polarizability of excitons in the device plane, and/or wherein the semiconductor layer has a thickness of not more than 5 nm.

**8.** The method of any one of the preceding claims, wherein excitons in the semiconductor layer structure (11) have a binding energy of at least 10 meV, preferably at least 50 meV.

**9.** The method of any one of the preceding claims,
wherein the semiconductor layer structure (11) comprises a semiconductor material selected from the group consisting of transition metal dichalcogenides, inorganic and organic hybrid perovskites, black phosphorous, bilayer graphene, silicene, antimonene, and semiconducting polymers,

wherein the semiconductor layer structure (11) preferably comprises a transition metal dichalcogenide monolayer.

10. The method of any one of the preceding claims, wherein the solid-state device (10) is operated at a temperature at which the excitons have a ratio between binding energy and linewidth in the lateral confining potential (V(x)) of at least 10.

11. The method of any one of the preceding claims, wherein the lateral confining potential (V(x)) causes the excitons to have at least two bound motional eigenstates in the lateral confining potential (V(x)), the eigenstates preferably being separated by an energy splitting at least 0.5 meV.

12. A device for laterally confining neutral excitons, the device comprising:

a semiconductor layer structure (11) defining a device plane;
an insulating first spacer layer (12) disposed on a first surface of the semiconductor layer structure (11);
a first gate electrode (13) arranged on the first spacer layer (12);
a second gate electrode (15; 13') arranged on the first spacer layer (14) or on an insulating second spacer layer (14) disposed on a second surface of the semiconductor layer structure (11) opposite to the first spacer layer (12);
a first voltage source (21) configured to apply a first gate voltage ($V_{BG}$) between the first gate electrode (13) and the semiconductor layer structure (11); and
a second voltage source (21) configured to apply a second gate voltage ($V_{TG}$; $V_{BG}'$) between the second gate electrode (15; 13') and the semiconductor layer structure (11),
the first and second gate voltages having polarities and magnitudes to cause an inhomogeneous electric field (F) in the semiconductor layer structure (11), the electric field (F) having an in-plane field component ($F_x$) whose magnitude varies along at least one confinement direction in the device plane, the magnitude of the in-plane field component ($F_x$) having a maximum along said confinement direction, whereby a lateral confining potential (V(x)) for neutral excitons is caused around the maximum.

13. The device of claim 12, wherein the second gate electrode (15) is arranged on the second spacer layer (14) and partially overlaps with the first gate electrode (13) when viewed along an out-of-plane direction (z) that is perpendicular to the device plane.

14. The device of claim 12 or 13,
wherein excitons in the semiconductor layer structure (11) have a binding energy of at least 10 meV, preferably at least 100 meV,
wherein preferably the semiconductor layer structure (11) comprises a transition metal dichalcogenide monolayer.

15. The device of any one of claims 12-14, further comprising an optical system (41-44) configured to irradiate the semiconductor layer structure (11) with incident light to excite neutral excitons in the semiconductor layer structure (11).

**FIG. 1**

**FIG. 2**

**FIG. 3**

FIG. 4

FIG. 5A

FIG. 5B

**FIG. 6**

**FIG. 7**

**FIG. 8**

**FIG. 9**

**FIG. 10**

**FIG. 11**

FIG. 12

FIG. 13

FIG. 14

**FIG. 15**

**FIG. 16**

**FIG. 17**

**FIG. 18**

**FIG. 19**

**FIG. 20**

**FIG. 21**

**FIG. 22**

**FIG. 23**

FIG. 24

FIG. 25

**FIG. 26**

**FIG. 27**

22 13' 13 21

$V_{BG}'$ $V_{BG}$

**FIG. 28**

+

↑↑↑↑↑↑↑↑↑↑↑↑↑↑↑↑

−

**FIG. 29**

−  +

**FIG. 30**

45
46
47
42
50
43
31
41
30
44
40
10
x
y
32
z

**FIG. 31**

27

Europäisches
Patentamt

European
Patent Office

Office européen
des brevets

# EUROPEAN SEARCH REPORT

**Application Number**

EP 21 15 6970

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/229653 A1 (ECOLE POLYTECHNIQUE FED LAUSANNE EPFL [CH]) 5 December 2019 (2019-12-05) * figures 1f, 2a, 4a, 4d, 4g * * page 11, line 33 - line 37 * * page 23, line 16 - line 21 * * page 24, line 25 - line 29 * * page 32, line 5 - line 9 * * page 19, line 5 - line 9 * | 1-15 | INV. H01L31/12 G02F1/015 |
| X | SARTHAK DAS ET AL: "Highly tunable layered exciton in bilayer WS_2: linear quantum confined Stark effect versus electrostatic doping", ARXIV.ORG, CORNELL UNIVERSITY LIBRARY, 201 OLIN LIBRARY CORNELL UNIVERSITY ITHACA, NY 14853, 13 November 2020 (2020-11-13), XP081813219, * figure 2c * | 12-15 | |
| A | TIANTIAN LI ET AL: "Spatially controlled electrostatic doping in graphene p-i-n junction for hybrid silicon photodiode", ARXIV.ORG, CORNELL UNIVERSITY LIBRARY, 201 OLIN LIBRARY CORNELL UNIVERSITY ITHACA, NY 14853, 22 September 2018 (2018-09-22), XP081410513, * figure 1 * | 1-15 | TECHNICAL FIELDS SEARCHED (IPC) H01L G02F G02B |

The present search report has been drawn up for all claims

| Place of search | Date of completion of the search | Examiner |
|---|---|---|
| Berlin | 3 August 2021 | Le Meur, M |

EPO FORM 1503 03.82 (P04C01)

## ANNEX TO THE EUROPEAN SEARCH REPORT
## ON EUROPEAN PATENT APPLICATION NO.

EP 21 15 6970

This annex lists the patent family members relating to the patent documents cited in the above-mentioned European search report.
The members are as contained in the European Patent Office EDP file on
The European Patent Office is in no way liable for these particulars which are merely given for the purpose of information.

03-08-2021

| Patent document cited in search report | Publication date | Patent family member(s) | Publication date |
|---|---|---|---|
| WO 2019229653 A1 | 05-12-2019 | US 2021217919 A1<br>WO 2019229653 A1 | 15-07-2021<br>05-12-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2007125418 A2
- WO 2018015738 A1
- KR 102045064 B1
- EP 3361516 A1

### Non-patent literature cited in the description

- **K. WANG et al.** Electrical control of charged carriers and excitons in atomically thin materials. *Nature Nanotechnology,* 2018, vol. 13, 128
- **RAPAPORT et al.** Electrostatic traps for dipolar excitons. *Phys. Rev. B,* 2005, vol. 72, 075428
- **A. GARTNER et al.** Micropatterned electrostatic traps for indirect excitons in coupled GaAs quantum wells. *Physical Review B,* 2007, vol. 76, 085304
- **G. J. SCHINNER et al.** Confinement and interaction of single indirect excitons in a voltage-controlled trap formed inside double InGaAs quantum wells. *Physical Review Letters,* 2013, vol. 110, 1
- **T. LOW et al.** Polaritons in layered two-dimensional materials. *Nature Materials,* 2017, vol. 16, 182-194
- **TAN, C. et al.** Recent Advances in Ultrathin Two-Dimensional Nanomaterials. *Chemical Reviews,* 2017, vol. 117, 6225-6331
- **C. TAN et al.** Recent advances in ultrathin two-dimensional nanomaterials. *Chemical Reviews,* 2017, vol. 117 (9), 6225-633
- **F. PIZZOCCHERO et al.** The hot pick-up technique for batch assembly of van der Waals heterostructures. *Nat. Commun.,* 2016, vol. 7, 11894
- **R. FRISENDA et al.** Recent progress in the assembly of nanodevices and van der Waals heterostructures by deterministic placement of 2D materials. *Chemical Society Reviews,* 2018, vol. 47, 53-68
- **Y. JUNG et al.** Transferred via contacts as a platform for ideal two-dimensional transistors. *Nat. Electron.,* 2019, vol. 2, 187-194